# EUROPÄISCHE PATENTSCHRIFT

(11) **EP 2 994 722 B1**
(45) Veröffentlichungstag und Bekanntmachung des Hinweises auf die Patenterteilung: **30.09.2020**
(21) Anmeldenummer: 14715927.1
(22) Anmeldetag: 08.04.2014
(51) Int. Cl.: G01D 5/245, G01D 5/347, G01D 5/241, H05K 1/02

(54) **MASSSTAB FÜR EIN LÄNGENMESSSYSTEM, LÄNGENMESSSYSTEM UND VERFAHREN ZUR HERSTELLUNG EINES LÄNGENMESSSYSTEMS**
SCALE FOR A LENGTH MEASURING SYSTEM, LENGTH MEASURING SYSTEM AND METHOD FOR PRODUCING A LENGTH MEASURING SYSTEM
RÈGLE GRADUÉE DESTINÉE À UN SYSTÈME DE MESURE DE LONGUEUR, SYSTÈME DE MESURE DE LONGUEUR ET PROCÉDÉ DE FABRICATION D'UN SYSTÈME DE MESURE DE LONGUEUR

(30) Priorität: 08.05.2013 DE 102013104782
(43) Veröffentlichungstag der Anmeldung: 16.03.2016
(73) Patentinhaber: Hamilton Bonaduz AG, 7402 Bonaduz (CH)
(72) Erfinder: ROMER, Hanspeter, CH-8340 Hinwil (CH); ALTMEYER, Manuel, CH-8640 Rapperswil (CH); RUPP, Martin, 9490 Vaduz (LI)
(74) Vertreter: Caspary, Karsten
(86) Internationale Anmeldenummer: PCT/EP2014/057063
(87) Internationale Veröffentlichungsnummer: WO 2014/180614

(56) Entgegenhaltungen:
- EP-A1- 2 357 451
- EP-A2- 0 986 289
- EP-A2- 1 770 374
- DE-A1- 10 117 193
- DE-A1-102007 036 836
- JP-A- 2006 170 790
- JP-A- 2012 149 891

## Beschreibung

Die vorliegende Erfindung liegt auf dem Gebiet der Messtechnik und Automatisierungstechnik und betrifft ein Messsystem zur Absolutwerterfassung von Winkeln oder Wegen, auch Messgeber, Längengeber oder Winkelencoder genannt.

Bekannte Längen- oder Winkelmesssysteme weisen eine Mehrzahl von gleichartigen Maßstäben und eine Sensoreinheit auf, die entlang der Maßstäbe bewegt wird und die darauf gespeicherten Informationen erfasst. Jeder Maßstab umfasst dabei mindestens eine Absolut- oder Relativspur, auch Inkrementalspur genannt, sowie eine Elementcodierung. Die Elementcodierung dient der Kennzeichnung bzw. Identifizierung der ansonsten identischen Maßstäbe und somit der Positionsbestimmung für die Sensoreinheit.

Ein bekanntes Messsystem ist beispielsweise aus der DE 101 17 193 A1 bekannt. Dort ist ein Messsystem mit mehreren nebeneinander angeordneten Maßstäben offenbart, die eine Absolutspur, eine Inkrementalspur und eine Codierspur aufweisen. Die Absolut- und Inkrementalspuren der einzelnen Maßstäbe sind identisch, nur die Codierspur unterscheidet sich jeweils von Maßstab zu Maßstab.

Nachteilig an dem Messsystem aus der DE 101 17 193 A1 ist, dass jeder einzelne Maßstab zwar identische Merkmale wie Absolut- und Inkrementalspur aufweist, die Codierspur jedoch individuell auf jeden einzelnen Maßstab aufgebracht werden muss. Dies ist insbesondere bei optischen Systemen sehr aufwendig.

Ein Messsystem nach dem kapazitiven Messprinzip mit als Elektroden auf einer Leiterplatte aufgebrachten Absolut- und Inkrementalspuren ist in der EP 0 836 076 A1 offenbart.

EP2 357 451 A1, JP 2006 170790 A, EP 1 770 374 A2 und JP 2012 149891 A offenbaren bekannte Beispiele von Codierungen zur Kennzeichnung von Maßstäben.

Eine Gerätecodierung durch Leiterplattensicherungen und ein Verfahren zur Kennzeichnung von Leiterplatten sind in der DE 10 2007 036 836 A1 bzw. der EP 0 986 289 A2 offenbart.

Es ist daher die Aufgabe der vorliegenden Erfindung, ein Messsystem bereitzustellen, das zumindest einige der oben genannten Nachteile überwindet und kostengünstig, in Massenfertigung, mit ausgereiften Technologien und ohne komplexe Fertigungstechniken hergestellt werden kann.

Diese Aufgabe wird durch den Gegenstand mit den Merkmalen des Anspruchs 1 erfüllt. Vorteilhafte Ausführungsformen sind in den abhängigen Ansprüchen beschrieben.

Erfindungsgemäß ist ein Maßstab für ein Längenmesssystem zur Absolutwerterfassung von Winkeln oder Wegen, der auf einer Leiterplatte (PCB) mindestens eine Spur zur Kennzeichnung von Längen- bzw. Winkelinformationen sowie eine Codierung zur Kennzeichnung des Maßstabs aufweist, wobei die Codierung mindestens ein Codierelement aufweist, das mindestens zwei Elektroden und eine elektrisch leitende Verbindung zwischen den Elektroden auf einem Isolatorsubstrat umfasst, wobei die leitende Verbindung dazu eingerichtet ist, zur Kennzeichnung des Maßstabs durch wahlweises Anlegen eines elektrischen Stroms an mindestens ein Codierelement irreversibel zerstört zu werden. Der entscheidende Vorteil des erfindungsgemäßen Maßstabs liegt darin, dass mehrere Maßstäbe identischen Typs auf dieselbe Art und Weise hergestellt werden können, und diese nach der Herstellung und vor der Montage oder nach dem Einbau in ein entsprechendes Messsystem codiert werden können. Die irreversible Zerstörung der leitenden Verbindung zwischen den entsprechenden Elektroden auf dem Isolatorsubstrat erfolgt ähnlich wie bei einer Schmelzsicherung, wobei die entsprechende thermische Leitfähigkeit des Substratmaterials und das Leitermaterial berücksichtigt werden müssen, damit die entsprechende Leistung zur Verfügung gestellt wird, um die elektrische Verbindung bis zum Durchschmelzen aufzuheizen. Derartige Maßstäbe eignen sich hervorragend für die massenhafte Herstellung, da die Strukturen für die Codierung auf der Leiterplatte für die Verarbeitung großer Stückzahlen hervorragend geeignet sind. Das Anlegen eines entsprechenden Stroms an die Elektroden erfolgt dediziert für jedes Codierelement durch Anschließen der entsprechenden Elektroden an eine Stromquelle, deren Leistung auf die Materialien wie oben beschrieben abgestimmt ist.

Mit besonderem Vorteil ist das mindestens eine Codierelement in eine Mehrzahl von Codiersegmenten segmentiert, wobei jedes Codiersegment zwei Elektroden mit einer leitenden Verbindung dazwischen aufweist. Dadurch ergibt sich eine genauere Messung, weil parasitäre Kapazitäten wegfallen. Jedes Codierelement weist dann zwar mehr leitende Verbindungen auf, die entsprechend irreversibel zu zerstören sind, die Längen- bzw. Winkelmessung am Maßstab kann jedoch weniger fehleranfällig erfolgen. Die Anordnung der Codiersegmente mit der leitenden Verbindung kann z.B. gleichmäßig über die Ausdehnung des Codierelements bzw. des Maßstabs sein. Bevorzugt sind jeweils die aneinander grenzenden oder auf einer gemeinsamen Seite der Leiterplatte vorhandenen Elektroden jedes Codiersegments als Referenzelektrode bzw. Groundelektrode ausgebildet.

Dabei ist zumindest eine Elektrode jedes Codiersegments potentialmäßig von der entsprechenden angrenzenden Elektrode getrennt. Das Anlegen des elektrischen Stroms zur irreversiblen Zerstörung erfolgt deshalb bei mehreren Codiersegmenten mehrfach, d.h. einmal pro Codiersegment. Dadurch, dass für die Codierung, also den Vorgang der irreversiblen Zerstörung, eine Hilfsvorrichtung mit einer der Anzahl der zu zerstörenden leitenden Verbindungen entsprechenden Anzahl von Kontaktelementen verwendet wird, ergibt sich kein wesentlicher Mehraufwand.

Bevorzugt weist der Maßstab eine Absolutspur und eine Inkrementalspur auf, wobei vorzugsweise die Absolutspur und/oder die Inkrementalspur als Leiterbahn, magnetische Bahn oder aufgedruckte Bahn ausgebildet sind. Wenn Absolut- und Inkrementalspur als Leiterbahn ausgebildet sind, dann ergibt sich der Vorteil, dass die Spuren einschließlich der Codierung bzw. der Codierspur auf dem Maßstab mit derselben Herstellungstechnik gefertigt werden können, was zu Einsparungen beim Fertigungsprozess führt.

Mit weiterem Vorteil ist die Leiterplatte fotochemisch, mittels Stanz- oder Drahtlegetechnik, mittels Siebdruck oder mittel Frästechnik herstellbar. Die genannten Technologien sind ausgereifte geeignete Verfahren zur Herstellung von Leiterplatten und bieten sich für die Massenherstellung des erfindungsgemäßen Maßstabs an. Bevorzugt ist das in der Halbleitertechnik meist eingesetzte fotochemische Herstellungsverfahren.

Damit die Zerstörung der leitenden Verbindung durch das Anlegen des Stroms auch tatsächlich irreversibel ist, weist die leitende Verbindung vorzugsweise eine Sollbruchstelle auf. Damit ist im besonderen Maße gewährleistet, dass die Codierung des Maßstabs präzise erfolgen kann.

Besonders bevorzugt ist es, dass sowohl eine intakte als auch eine irreversibel zerstörte leitende Verbindung von einer Person visuell überprüfbar ist. Damit lässt sich nicht nur anhand eines Sensors überprüfen, ob die richtige Codierung für jeden einzelnen Maßstab korrekt durchgeführt worden ist, sondern auch von einem menschlichen Auge, mit oder ohne optische Hilfsmittel wie einer Lupe oder dergleichen. Dies bietet Vorteile beim Einbau der entsprechenden Maßstäbe.

Weiterhin erfindungsgemäß ist ein Längenmesssystem zur Absolutwerterfassung von Winkeln oder Wegen mit einer Mehrzahl von nebeneinander angeordneten Maßstäben, die wie oben definiert aufgebaut sind, einer ersten Sensoreinheit mit mindestens einem Sensor zur Erfassung der Längen- bzw. Winkelinformationen und der Codierung jedes der Mehrzahl von Maßstäben, wobei die Längen- bzw. Winkelinformationen auf der mindestens einen Spur jedes Maßstabs identisch sind, und wobei die Codierung jedes Maßstabs des Längenmesssystems derart ausgebildet ist, dass sie sich in mindestens einem Codierelement von einem anderen Maßstab unterscheidet. Die Bildung eines solchen Längenmesssystems mit einer Mehrzahl von besonders codierten Maßstäben kann damit einfach erfolgen, weil das Codierungsverfahren für jeden einzelnen Maßstab dieselbe Infrastruktur nutzen kann und ebenfalls einfach aufgebaut ist. Die Codierung der einzelnen Maßstäbe kann flexibel entweder vor dem Anordnen der einzelnen Maßstäbe zu einem Gesamtmesssystem erfolgen oder auch danach, wenn die einzelnen Maßstäbe schon nebeneinander angeordnet sind.

Vorteilhafterweise umfasst das Längenmesssystem eine zweite Sensoreinheit mit mindestens einem Sensor zur Erfassung der Längen- bzw. Winkelinformationen und der Codierung und eine Steuereinheit. Damit können beim Übergang von nebeneinander angeordneten Maßstäben sämtliche Spuren sicher erfasst werden. Die Steuereinheit schaltet dabei zwischen der ersten und der zweiten Sensoreinheit je nach Vollständigkeit des erfassten Signals hin und her. Die erste und zweite Sensoreinheit sind dabei vorzugsweise identisch ausgebildet, um zusätzlichen Aufwand zu sparen. Mit anderen Worten wird dabei durch die identische zweite Sensoreinheit eine Redundanz geschaffen, die speziell für die Erfassung der Übergänge der Maßstäbe wichtig ist.

Das Messprinzip der Sensoren in der ersten bzw. zweiten Sensoreinheit beruht vorzugsweise auf einem optischen, magnetischen, induktiven, elektromagnetischen oder kapazitiven Messverfahren oder aus einer Kombination davon. Derartige Sensoren sind im Prinzip bekannt, sie basieren auf physikalischen Messverfahren bzw. Parametern, z. B. einer variablen Induktivität oder einer variablen Kapazität.

Weiterhin erfindungsgemäß ist ein Verfahren zur Herstellung eines Längenmesssystems zur Absolutwerterfassung von Winkeln oder Wegen, das folgende Schritte umfasst: a) Bereitstellen einer Mehrzahl von zunächst identischen Maßstäben wie oben beschrieben, wobei die Längen- bzw. Winkelinformationen auf der mindestens einen Spur jedes Maßstabs und die Codierelemente jedes Maßstabs des Längenmesssystems zunächst identisch sind, b) Anordnen der Mehrzahl von Maßstäben nebeneinander, c) Kennzeichnen jedes der Mehrzahl von Maßstäben durch wahlweises Anlegen eines Stroms an mindestens ein Codierelement, wobei die leitenden Verbindungen irreversibel zerstört werden, so dass jeder der Mehrzahl von Maßstäben nunmehr eine unterschiedliche Codierung aufweist, wobei die Schritte b) und c) auch in umgekehrter Reihenfolge durchführbar sind.

Die vorliegende Erfindung wird nachfolgend anhand von bevorzugten Ausführungsformen unter Bezugnahme auf die Zeichnungen beschrieben, in denen:
- Fig. 1: eine schematische Darstellung einer ersten Ausführungsform des erfindungsgemäßen Maßstabs zeigt,
- Fig. 2: eine schematische Darstellung einer zweiten Ausführungsform des erfindungsgemäßen Maßstabs zeigt,
- Fig. 3: eine schematische Darstellung eines Längenmesssystems gemäß der ersten Ausführungsform zeigt,
- Fig. 4: eine schematische Darstellung eines Längenmesssystems gemäß der zweiten Ausführungsform des erfindungsgemäßen Maßstabs zeigt,
- Fig. 5: eine schematische Darstellung der Vorderseite einer dritten Ausführungsform des erfindungsgemäßen Maßstabs zeigt, und
- Fig. 6: eine schematische Darstellung eines Ausschnitts der Rückseite der dritten Ausführungsform des erfindungsgemäßen Maßstabs zeigt.

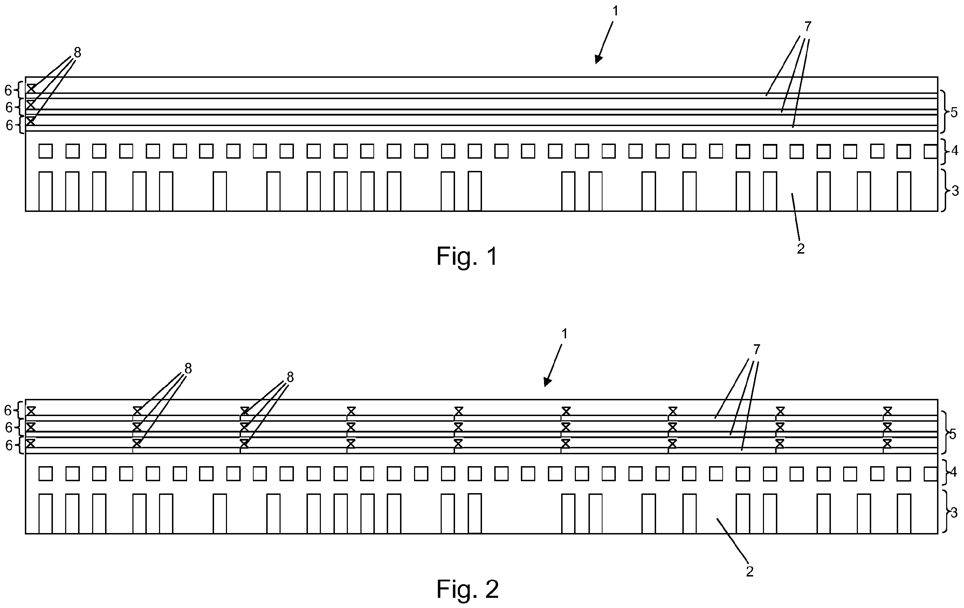

Fig. 1 zeigt eine schematische Darstellung einer ersten Ausführungsform des erfindungsgemäßen Maßstabs. Der Maßstab 1 umfasst eine auf einem Isolatorsubstrat 2 aufgebrachte Absolutspur 3, eine Relativ- oder Inkrementalspur 4 und eine Codierung 5, die auch als Codierspur bezeichnet wird. Die Absolutspur 3 und die Relativspur 4 sind in der dargestellten Ausführungsform als leitende Abschnitte bzw. Leiterbahnen auf dem Isolatorsubstrat 2 auf der Vorderseite des Maßstabs aufgebracht. Sie können aber auch auf der Rückseite aufgebracht sein. Alternativ können Absolut- und Relativspur 3, 4 auch als optische Spuren mit hellen und dunklen Abschnitten ausgebildet sein. In ähnlicher Weise können die entsprechend markierten Abschnitte auch eine unterschiedliche magnetische Struktur aufweisen, d.h. es wechseln sich magnetische und nichtmagnetische Abschnitte ab. Die beiden Spuren 3 und 4 sind damit mit einem geeigneten Sensor erfassbar.

Oberhalb der Absolutspur 3 und der Relativspur 4 ist die drei Codierelemente 6 aufweisende Codierung 5 angeordnet. Ein Codierelement 6 weist zwei Elektroden 7 und eine leitende Verbindung 8 zwischen den beiden Elektroden 7 auf. In Fig. 1 erkennt man eine als Leiterbahn ausgebildete erste Elektrode 7, die zweite, nicht in Fig. 1 sichtbare Elektrode ist beispielsweise als Referenzelektrode auf der Rückseite der Leiterplatte (PCB) angeordnet. Die zweite Elektrode kann auch auf der Vorderseite der Leiterplatte (PCB) vorgesehen sein. Das Codierelement 6 erstreckt sich in der dargestellten Ausführungsform über die gesamte Länge des Maßstabs 1. Die eine Elektrode 7 ist wie in Fig. 1 dargestellt auf der Vorderseite des Leiterplattensubstrats 2 angeordnet. Es ist auch eine andere Anordnung, beispielsweise auf unterschiedlichen Seiten der Leiterplatte möglich.

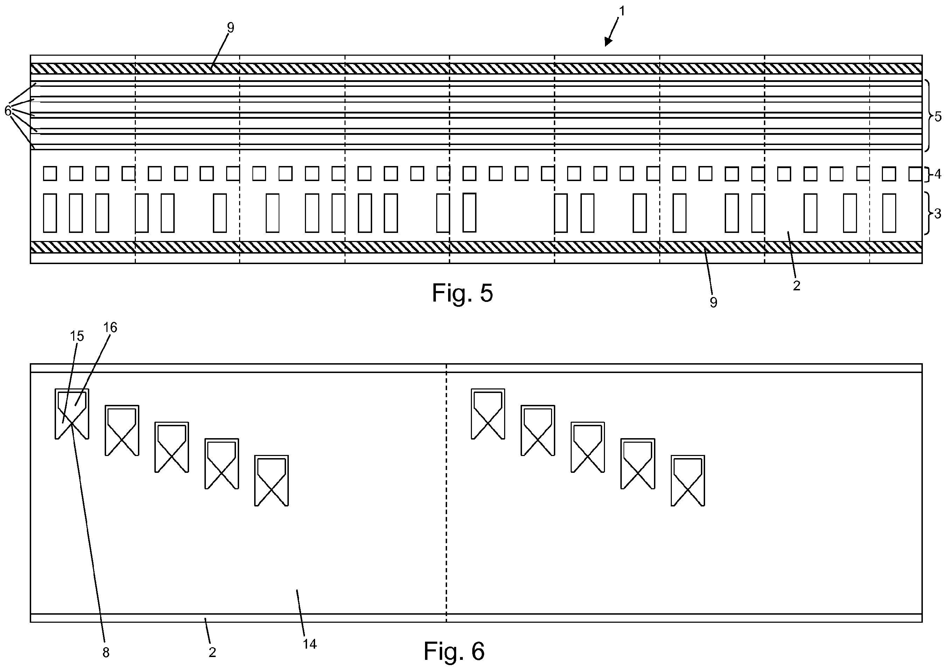

Die leitende Verbindung 8 jedes Codierelements 6 ist in dieser Ausführungsform als Schmelzsicherung zwischen den Elektroden 7 ausgebildet, wobei alle drei leitenden Verbindungen in Längsrichtung auf einer Höhe (in Fig. 1 links) ausgebildet sind. Eine mögliche Ausgestaltung der leitenden Verbindung 8 wird weiter unten beispielhaft unter Bezugnahme auf die Fig. 5 und 6 erläutert. Durch die Anordnung von genau drei Codierelementen 6 mit jeweils einer leitenden Verbindung 8, die irreversibel zerstörbar ist, ergibt sich eine maximale Anzahl von 2³, also acht unterschiedlichen Codierungsmöglichkeiten. Es können folglich acht Maßstäbe nebeneinander angeordnet werden, wobei jeder im funktionsbereiten Zustand eine unterschiedliche Codierung aufweist.

In Fig. 2 ist eine zweite Ausführungsform des erfindungsgemäßen Maßstabs 1 dargestellt. Die auf dem Isolatorsubstrat 2 angeordneten Absolut- und Relativspuren 3, 4 sind identisch zur ersten, in Fig. 1 dargestellten Ausführungsform. Die Codierung 5 ist ebenfalls analog zu Fig. 1 mittels dreier Codierelemente 6 ausgebildet. Allerdings weist jedes Codierelement 6 in Fig. 2 nicht nur eine, sondern eine Mehrzahl von, hier neun, leitenden Verbindungen 8 auf, die jeweils zwischen zwei Elektroden angeordnet sind, von denen eine auf der Vorderseite sichtbar ist. Sämtliche leitenden Verbindungen 8 eines Codierelements 6 sind demnach auf identische Weise mit den Elektroden 7 verbunden. Da die neun leitenden Verbindungen 8 hier in im Wesentlichen gleichen Abständen über die Länge des Codierelements 6 und damit den Maßstab 1 verteilt sind, sind die Eigenkapazitäten der Elektroden 7, also der Leitungsbahnen kleiner und haben beispielsweise bei der kapazitiven Erfassung der Codierung einen geringeren negativen Einfluss. Ein bevorzugt ausgeführter Maßstab 1 weist z. B. eine Länge von 50 cm auf, wobei die Abstände der leitenden Verbindungen 8 etwa 22 mm betragen, was sich als besonders vorteilhaft für die Messung erwiesen hat. Es sind auch größere oder kleinere Abstände möglich.

Die Individualisierung eines Maßstabs 1 nach der Ausführungsform aus Fig. 2 erfolgt analog zur Ausführungsform nach Fig. 1: an die Elektroden 7 jedes Codierelements 6 wird gleichzeitig oder auch nacheinander ein elektrischer Strom angelegt, wodurch jeweils alle leitenden Verbindungen 8 eines Codierelements 6 irreversibel zerstört werden. Für die wirksame Codierung jedes Codierelements 6 muss z. B. mindestens jede Elektrode des entsprechenden Codiersegments und die Ground- bzw. Referenzelektrode kontaktiert werden.

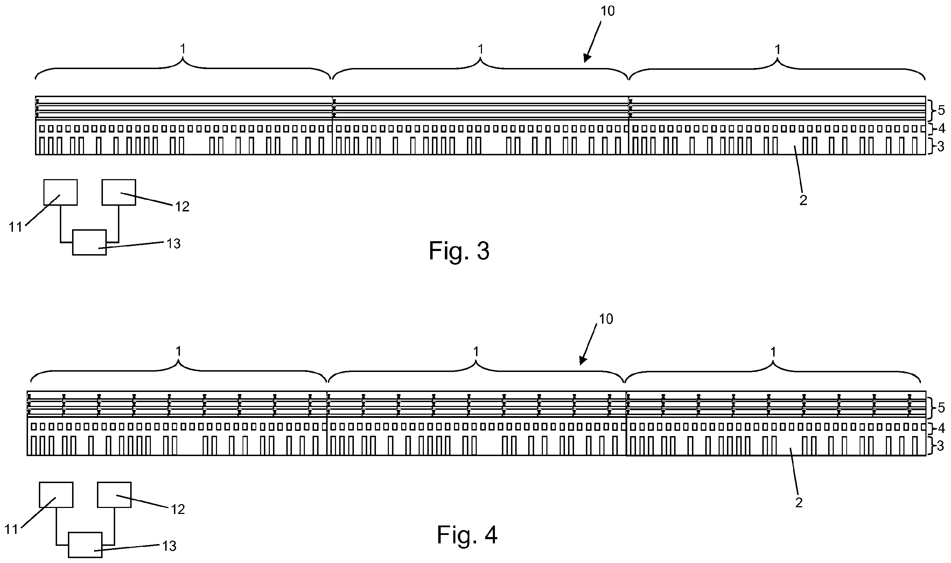

Fig. 3 zeigt eine schematische Darstellung eines Längenmesssystems 10 gemäß der ersten Ausführungsform der vorliegenden Erfindung, wobei beispielhaft drei Maßstäbe 1, die identisch mit dem in Fig. 1 dargestellten Maßstab sind, nebeneinander angeordnet sind. Der Übergang zwischen den Maßstäben muss möglichst nahtlos und exakt sein, so dass Messungenauigkeiten so weit wie möglich vermieden werden. Auch eine möglichst exakte Ausrichtung der Maßstäbe in Längsrichtung ist wichtig. Durch die heute möglichen Fertigungstechniken, insbesondere für Leiterplatten (PCBs), ist dies in aller Regel ohne großen Aufwand gewährleistet.

Eine erste Sensoreinheit 11 und eine zweite Sensoreinheit 12 sind derart in der Nähe des Längenmesssystems 10 angeordnet, dass sie die Absolut- und Relativspur 3, 4 bzw. die Codierung 5 erfassen können. In der Darstellung der Fig. 3 sind die Sensoreinheiten 11, 12 aus Anschaulichkeitsgründen neben dem Längenmesssystem 10 angeordnet. Es versteht sich, dass bei einem senkrechten Erfassungswinkel, d.h. senkrecht zur Zeichenebene und zur Ebene der Maßstäbe, die Sensoreinheiten über den Maßstäben angeordnet sind, um eine optimale Erfassung zu ermöglichen. Sensoren in den beiden Sensoreinheiten 11, 12 arbeiten beispielsweise nach dem optischen Prinzip, bei dem die Abfolge von dunklen und hellen Stellen mittels entsprechender optischer Sender und Empfänger erfasst wird. Es sind auch andere Ausführungen für die Sensoren möglich, d.h. eine magnetische, induktive, elektromagnetische oder kapazitive Messung oder eine Kombination daraus.

In der in den Fig. 3 und 4 dargestellten Ausführungsform erfassen der Sensor bzw. die Sensoren der ersten und zweiten Sensoreinheit 11, 12 die Codierung 5 beispielsweise nach einem kapazitiven Messverfahren mittels eines kapazitiven Abstandssensors, bei dem der Sensor und eine leitende Gegenfläche einen elektrischen Kondensator bilden, wobei die leitende Gegenfläche, d.h. die Leiterbahnen auf dem Maßstab, und der Abstand die Kapazität bestimmt. Es ist aber auch möglich, die Codierung 5 mit anderen Sensoren zu erfassen, beispielsweise mittels eines induktiven Sensors.

Eine Steuereinheit 13 erfasst die Messsignale der ersten und zweiten Sensoreinheiten 11, 12 und wertet diese aus. Um die Übergänge zwischen den Maßstäben exakt erfassen zu können, erkennt die Steuereinheit 13 anhand der Signale der Sensoreinheiten 11 bzw. 12, ob ein Übergang vorhanden ist. Dementsprechend wird dann auf die jeweils nicht am Übergang positionierte Sensoreinheit geschaltet und die Signale werden von dort empfangen und ausgewertet, um die erfasste Längeninformation auf dem Längenmassstab direkt oder indirekt ausgeben zu können.

Fig. 4 ist eine zu Fig. 3 analoge Darstellung, wobei in Fig. 4 schematisch drei Maßstäbe 1 gemäß Fig. 2 nebeneinander angeordnet sind. Die Anordnung der Sensoreinheiten 11, 12 sowie der Steuereinheit 13 und die Funktion der Elemente sind identisch zur mit Bezug auf Fig. 3 beschriebenen Ausführungsform.

Fig. 5 zeigt eine schematische Darstellung der Vorderseite einer dritten Ausführungsform des erfindungsgemäßen Maßstabs. Wie in den oben beschriebenen ersten und zweiten Ausführungsformen weist der erfindungsgemäße Maßstab 1 auf einer Leiterplatte (PCB) 2 eine Absolutspur 3, eine Relativspur 4 und eine Codierung bzw. Codierspur 5 auf. In dieser dritten Ausführungsform umfasst die Codierung 5 fünf Codierelemente 6, die in Längsrichtung jeweils in eine Mehrzahl von Codiersegmenten aufgeteilt sind. Die einzelnen Codiersegmente jedes Codierelements 6 stellen auf der in Fig. 5 dargestellten Vorderseite eine Elektrode dar, die jeweils nicht mit den in Längsrichtung angrenzenden Elektroden des nächsten Codiersegments leitend verbunden. Jeweils an den Rändern weist der Maßstab 1 auf der Vorderseite eine Referenzelektrode 9 auf, die die zweite Elektrode für jedes Elektrodenpaar darstellt. Die leitenden Verbindungen 8 jedes Codierelements 6 sind in Fig. 5 nicht abgebildet, da sie in der dargestellten Ausführungsform nicht in dieser Ansicht sichtbar sind, wie im Folgenden erläutert ist.

Fig. 6 zeigt eine schematische Darstellung eines Ausschnitts der Rückseite der dritten Ausführungsform des erfindungsgemäßen Maßstabs mit zwei Codiersegmenten. Aus Darstellungsgründen weisen die Abbildungen aus Fig. 5 und Fig. 6 unterschiedliche Größenordnungen auf und sind deshalb als rein schematisch anzusehen. In Fig. 6 weist der Maßstab 1 auf der Rückseite der Leiterplatte 2 großflächig einen leitenden Bereich 14 auf, der mit der Referenzelektrode 9 auf der Vorderseite durchkontaktiert, d.h. leitend verbunden, ist und deshalb auf dem Potential der Referenzelektrode 9 liegt.

Der leitende Bereich 14 ist auf Höhe jeder der fünf auf der Vorderseite vorhandenen Codierelemente 6 mit einer der Anzahl von Codierelementen 6 entsprechenden Anzahl von nichtleitenden Flächen 15 versehen. Jede nichtleitende Fläche 15 ist einem Codierelement 6 zugeordnet und umgibt eine Elektrode 16, die auf einer Seite eine leitende Verbindung 8 aufweist, die zum Zwecke der Codierung als irreversibel zerstörbar ausgebildet ist. Die leitende Verbindung 8 ist in dieser Ausführungsform eine Verbindung zwischen der Elektrode 16 auf der Rückseite und der zugehörigen Elektrode des Codierelements 6 auf der Vorderseite des Maßstabs 1. Derartige Durchkontaktierungen (engl. vertical interconnect access; VIA) sind bei integrierten Schaltungen seit langem üblich und dienen hauptsächlich dazu, bei Platzmangel auf einer Seite sowohl Vorder- als auch Rückseite einer Leiterplatte (PCB) mit Bauelementen zu bestücken. Da in den Fig. 5 und 6 Draufsichten auf die Vorder- bzw. Rückseite eines Maßstabs 1 dargestellt sind, sind die Durchkontaktierungen nicht abgebildet. Auch bei der Ausführungsform der vorliegenden Erfindung wurde aus Platzgründen eine Elektrode 16 eines Codierelements 6 auf der Rückseite des Maßstabs 1 angeordnet. Weil die auf der Rückseite des Maßstabs 1 vorhandenen Elemente, d.h. die nichtleitenden Flächen 15, die Elektroden 16 und die leitende Verbindung 8, nicht alle direkt untereinander angeordnet werden können, sind sie seitlich versetzt positioniert. Bei einer entsprechenden Größe des Maßstabs können sie jedoch auch untereinander angeordnet sein, wie in den ersten und zweiten Ausführungsformen dargestellt.

Das Aufbrechen bzw. Zerstören der leitenden Verbindung(en) 8 kann bei der in den Fig. 5 und 6 gezeigten Ausführungsform von beiden Seiten des Maßstabs 1 her erfolgen, da beide Elektroden 6, 9 auf der Vorderseite sowie der leitende Bereich 14 und die Elektroden 16 auf der Rückseite vorhanden und zugänglich sind. Es ist auch möglich, auf unterschiedlichen Seiten zu kontaktieren, um die Zerstörung und damit die Codierung herbeizuführen. Dazu wird eine besonders geeignete Kontaktier- oder Codiervorrichtung eingesetzt, die z.B. mehrere Kontaktelemente zur gleichzeitigen Kontaktierung einer Mehrzahl von Elektroden aufweisen kann. Die Kontaktier- oder Codiereinrichtung wird entsprechend programmiert und führt automatisch die Codierung jedes Maßstabs durch. Dabei ist es möglich, dass vor oder nach der finalen Anordnung der Maßstäbe in einem Messsystem die Codierung durchgeführt wird.

Das Durchbrechen bzw. Zerstören der leitenden Verbindung 8 bei jedem Codierelement 6 bzw. in jedem Codiersegment bedient sich in den bevorzugten Ausführungsformen der Eigenschaften und der Funktionalität einer PCB Schmelzsicherung. Dabei ist sicherzustellen, dass die Potentialunterschiede und Ströme bei Anlegen der Kontaktier- oder Codiereinrichtung ausreichend dimensioniert sind, damit eine zuverlässige und dauerhafte Zerstörung der leitenden Verbindung 8 gewährleistet ist.

Die vorliegende Erfindung ist nicht nur auf Längenmesssysteme in einer geraden Ausrichtung, sondern auch auf Winkelmesssysteme mit entsprechenden Kreissegment-Maßstäben anwendbar.

Mit dem erfindungsgemäßen Gegenstand wird ein Messsystem bereitgestellt, das kostengünstig, in Massenfertigung, mit ausgereiften Technologien und ohne komplexe Fertigungstechniken hergestellt werden kann. Es gewährleistet eine zuverlässige Messung und ist flexibel und variabel einsetzbar.

## Patentansprüche

1. Maßstab (1) für ein Längenmesssystem zur Absolutwerterfassung von Winkeln oder Wegen, der eine Leiterplatte (2) und auf der Leiterplatte (2) mindestens eine Spur (3, 4) zur Kennzeichnung von Längen- bzw. Winkelinformationen sowie eine Codierung (5) zur Kennzeichnung des Maßstabs (1) aufweist,
**dadurch gekennzeichnet, dass**
die Codierung (5) mindestens ein Codierelement (6) aufweist, das mindestens zwei Elektroden (7, 9, 14) und eine elektrisch leitende Verbindung (8) zwischen den Elektroden (7, 9, 14) auf einem Isolatorsubstrat umfasst, wobei die leitende Verbindung (8) dazu eingerichtet ist, zur Kennzeichnung des Maßstabs (1) durch wahlweises Anlegen eines elektrischen Stroms an mindestens ein Codierelement (6) irreversibel zerstört zu werden.

2. Maßstab (1) nach Anspruch 1, **dadurch gekennzeichnet, dass** das mindestens eine Codierelement (6) in eine Mehrzahl von Codiersegmenten segmentiert ist, wobei jedes Codiersegment zwei Elektroden (7, 9, 14) mit einer leitenden Verbindung (8) dazwischen aufweist.

3. Maßstab (1) nach Anspruch 2, **dadurch gekennzeichnet, dass** die Elektroden (7, 9, 14) jedes Codiersegments potentialmäßig getrennt sind.

4. Maßstab (1) nach einem der vorhergehenden Ansprüche, **dadurch gekennzeichnet, dass** er eine Absolutspur (3) und eine Inkrementalspur (4) aufweist.

5. Maßstab (1) nach Anspruch 4, **dadurch gekennzeichnet, dass** die Absolutspur (3) und/oder die Inkrementalspur (4) als Leiterbahn, magnetische Bahn oder aufgedruckte Bahn ausgebildet sind.

6. Maßstab (1) nach einem der vorhergehenden Ansprüche, **dadurch gekennzeichnet, dass** die Leiterplatte (2) fotochemisch, mittels Stanz- oder Drahtlegetechnik, mittels Siebdruck oder mittels Frästechnik herstellbar ist.

7. Maßstab (1) nach einem der vorhergehenden Ansprüche, **dadurch gekennzeichnet, dass** die leitende Verbindung (8) eine Sollbruchstelle aufweist.

8. Maßstab (1) nach einem der vorhergehenden Ansprüche, **dadurch gekennzeichnet, dass** sowohl eine intakte als auch eine irreversibel zerstörte leitende Verbindung (8) von einer Person visuell überprüfbar ist.

9. Längenmesssystem (10) zur Absolutwerterfassung von Winkeln oder Wegen mit
einer Mehrzahl von nebeneinander angeordneten Maßstäben (1) nach einem der vorhergehenden Ansprüche,
einer ersten Sensoreinheit (11) mit mindestens einem Sensor zur Erfassung der Längen- bzw. Winkelinformationen und der Codierung (5) jedes der Mehrzahl von Maßstäben (1),
wobei die Längen- bzw. Winkelinformationen auf der mindestens einen Spur (3, 4) jedes Maßstabs (1) identisch sind, und
wobei die Codierung (5) jedes Maßstabs (1) des Längenmesssystems (10) derart ausgebildet ist, dass sie sich in mindestens einem Codierelement (6) von einem anderen Maßstab (1) unterscheidet.

10. Längenmesssystem (10) nach Anspruch 9, **dadurch gekennzeichnet, dass** es eine zweite Sensoreinheit (12) mit mindestens einem Sensor zur Erfassung der Längen- bzw. Winkelinformationen und der Codierung (5) jedes der Mehrzahl von Maßstäben (1) und eine Steuereinheit (13) aufweist.

11. Längenmesssystem (10) nach einem der Ansprüche 9 bis 10, **dadurch gekennzeichnet, dass** das Messprinzip der Sensoren der ersten und/oder zweiten Sensoreinheit (11, 12) auf einem optischen, magnetischen, induktiven, elektromagnetischen oder kapazitiven Messverfahren oder aus einer Kombination dieser Messverfahren beruht.

12. Verfahren zur Herstellung eines Längenmesssystems (10) zur Absolutwerterfassung von Winkeln oder Wegen, das folgende Schritte umfasst:
a) Bereitstellen einer Mehrzahl von zunächst identischen Maßstäben (1) nach einem der Ansprüche 1 bis 8, wobei die Längen- bzw. Winkelinformationen auf der mindestens einen Spur (3, 4) jedes Maßstabs (1) und die Codierelemente (6) jedes Maßstabs (1) des Längenmesssystems (10) zunächst identisch sind,
b) Anordnen der Mehrzahl von Maßstäben (1) nebeneinander,
c) Kennzeichnen jedes der Mehrzahl von Maßstäben (1) durch wahlweises Anlegen eines Stroms an mindestens ein Codierelement (6), wobei die leitenden Verbindungen (8) irreversibel zerstört werden,
so dass jeder der Mehrzahl von Maßstäben (1) nunmehr eine unterschiedliche Codierung (5) aufweist,
wobei die Schritte b) und c) auch in umgekehrter Reihenfolge durchführbar sind.

## Claims

1. Scale (1) for a length measuring system for recording the absolute value of angles or paths, comprising a conductor plate (2) and at least one track (3, 4) on the conductor plate (2) for marking length and angle data as well as a coding (5) for marking the scale (1), **characterised in that** the coding (5) has at least one coding element (6) which comprises at least two electrodes (7, 9, 14) and an electrically conductive connection (8) between the electrodes (7, 9, 14) on an insulator substrate, wherein the conductive connection (8) is set up to be destroyed irreversibly by selectively applying an electric current to at least one coding element (6) in order to mark the scale (1).

2. Scale (1) according to claim 1 **characterised in that** the at least one coding element (6) is segmented into a plurality of coding segments wherein each coding segment has two electrodes (7, 9, 14) with a conductive connection (8) inbetween.

3. Scale (1) according to claim 2 **characterised in that** the electrodes (7, 9, 14) of each coding segment are separated potential-wise.

4. Scale (1) according to one of the preceding claims **characterised in that** it has one absolute track (3) and one incremental track (4).

5. Scale (1) according to claim 4 **characterised in that** the absolute track (3) and/or the incremental track (4) are configured as a conductor path, magnetic path or imprinted path.

6. Scale (1) according to one of the preceding claims, **characterised in that** the conductor plate (2) can be manufactured photo-chemically, by means of punching or wire embedding, by means of screen printing or by means of milling.

7. Scale (1) according to one of the preceding claims **characterised in that** the conductive connection (8) has a predetermined breaking point.

8. Scale (1) according to one of the preceding claims **characterised in that** both an intact and also an irreversibly destroyed conductive connection (8) can be checked visually by a person.

9. Length measuring system (10) for recording the absolute value of angles or paths with a plurality of scales (1), according to one of the preceding claims, arranged next to one another with a first sensor unit (11) with at least one sensor for recording the length and angle data and the coding (5) of each of the plurality of scales (1), wherein the length and angle data on the at least one track (3, 4) of each scale (1) are identical, and wherein the coding (5) of each scale (1) of the length measuring system (10) is configured in such a way that it differs in at least one coding element (6) from another scale (1).

10. Length measuring system (10) according to claim 9 **characterised in that** it comprises a second sensor unit (12) with at least one sensor for recording the length and angle data and the coding (5) of each of the plurality of scales (1), and a control unit (13).

11. Length measuring system (10) according to one of claims 9 to 10 **characterised in that** the measuring principle of the sensors of the first and/or second sensor unit (11, 12) is based on an optical, magnetic, inductive, electromagnetic or capacitive measuring process or on a combination of these measuring processes.

12. Method for producing a length measuring system (10) for recording the absolute value of angles or paths, comprising the following steps:
a) providing a plurality of initially identical scales (1) according to one of claims 1 to 8 wherein the length and angle data on the at least one track (3, 5) of each scale (1), and the coding elements (6) of each scale (1) of the length measuring system (10) are initially identical;
b) arranging the plurality of scales (1) side by side;
c) marking each of the plurality of scales (1) by selectively applying a current to at least one coding element (6) wherein the conductive connections (8) are irreversibly destroyed
so that each of the plurality of scales (1) now has a different coding (5) wherein steps b) and c) can also be carried out in reverse order.

## Revendications

1. Règle graduée (1) pour un système de mesure de longueur pour la détection de valeur absolue d'angles ou de trajets qui présente une carte de circuit imprimé (2) et sur la carte de circuit imprimé (2) au moins une piste (3, 4) pour la caractérisation d'informations de longueur ou d'angle ainsi qu'un codage (5) pour la caractérisation de la règle graduée (1),
**caractérisée en ce que**
le codage (5) présente au moins un élément de codage (6) qui comporte au moins deux électrodes (7, 9, 14) et une liaison électroconductrice (8) entre les électrodes (7, 9, 14) sur un substrat isolant, dans laquelle la liaison conductrice (8) est aménagée afin d'être détruite de manière irréversible pour la caractérisation de la règle graduée (1) par application au choix d'un courant électrique à au moins un élément de codage (6).

2. Règle graduée (1) selon la revendication 1, **caractérisée en ce que** l'au moins un élément de codage (6) est segmenté en une pluralité de segments de codage, dans laquelle chaque segment de codage présente deux électrodes (7, 9, 14) avec une liaison conductrice (8) entre elles.

3. Règle graduée (1) selon la revendication 2, **caractérisée en ce que** les électrodes (7, 9, 14) de chaque segment de codage sont séparées en potentiel.

4. Règle graduée (1) selon l'une des revendications précédentes, **caractérisée en ce qu'**elle présente une piste absolue (3) et une piste incrémentielle (4).

5. Règle graduée (1) selon la revendication 4, **caractérisée en ce que** la piste absolue (3) et/ou la piste incrémentielle (4) sont réalisées comme bande conductrice, bande magnétique ou bande imprimée.

6. Règle graduée (1) selon l'une des revendications précédentes, **caractérisée en ce que** la carte de circuit imprimé (2) peut être fabriquée de manière photochimique, au moyen de la technique d'estampage ou de pose de fils, au moyen de la sérigraphie ou au moyen de la technique de fraisage.

7. Règle graduée (1) selon l'une des revendications précédentes, **caractérisée en ce que** la liaison conductrice (8) présente un point destiné à la rupture.

8. Règle graduée (1) selon l'une des revendications précédentes, **caractérisée en ce que** non seulement une liaison conductrice (8) intacte mais aussi détruite de manière irréversible peut être vérifiée visuellement par une personne.

9. Système de mesure de longueur (10) pour la détection de valeur absolue d'angles ou de trajets avec
une pluralité de règles graduées (1) agencées les unes à côté des autres selon l'une des revendications précédentes,
une première unité de capteur (11) avec au moins un capteur pour la détection des informations de longueur ou d'angle et du codage (5) de chacune de la pluralité de règles graduées (1),
dans lequel les informations de longueur ou d'angle sont identiques sur l'au moins une piste (3, 4) de chaque règle graduée (1), et
dans lequel le codage (5) de chaque règle graduée (1) du système de mesure de longueur (10) est réalisé de telle manière qu'il se distingue dans au moins un élément de codage (6) d'une autre règle graduée (1).

10. Système de mesure de longueur (10) selon la revendication 9, **caractérisé en ce qu'**il présente une seconde unité de capteur (12) avec au moins un capteur pour la détection des informations de longueur ou d'angle et du codage (5) de chacune de la pluralité de règles graduées (1) et une unité de commande (13).

11. Système de mesure de longueur (10) selon l'une des revendications 9 à 10, **caractérisé en ce que** le principe de mesure des capteurs de la première et/ou seconde unité de capteur (11, 12) repose sur un procédé de mesure optique, magnétique, inductif, électromagnétique ou capacitif ou à partir d'une combinaison de ces procédés de mesure.

12. Procédé de fabrication d'un système de mesure de longueur (10) pour la détection de valeur absolue d'angles ou de trajets qui comporte les étapes suivantes :
a) la fourniture d'une pluralité de règles graduées (1) tout d'abord identiques selon l'une des revendications 1 à 8, dans lequel les informations de longueur ou d'angle sont tout d'abord identiques sur l'au moins une piste (3, 4) de chaque règle graduée (1) et les éléments de codage (6) de chaque règle graduée (1) du système de mesure de longueur (10),
b) l'agencement de la pluralité de règles graduées (1) les unes à côté des autres,
c) la caractérisation de chacune de la pluralité de règles graduées (1) par application au choix d'un courant à au moins un élément de codage (6), dans lequel les liaisons conductrices (8) sont détruites de manière irréversible,
de sorte que chacune de la pluralité de règles graduées (1) présente désormais un codage différent (5),
dans lequel les étapes b) et c) peuvent aussi être réalisées dans l'ordre inversé.
